(19) **Europäisches Patentamt / European Patent Office / Office européen des brevets**

(11) **EP 4 538 412 A1**

(12) **EUROPEAN PATENT APPLICATION**
published in accordance with Art. 153(4) EPC

(43) Date of publication:
**16.04.2025 Bulletin 2025/16**

(21) Application number: **23823856.2**

(22) Date of filing: **09.06.2023**

(51) International Patent Classification (IPC):
**C23C 14/34** (2006.01)  **C04B 35/58** (2006.01)
**C04B 35/64** (2006.01)  **H01L 21/203** (2006.01)

(52) Cooperative Patent Classification (CPC):
**C04B 35/58; C04B 35/64; C23C 14/34;
H01L 21/2015**

(86) International application number:
**PCT/JP2023/021587**

(87) International publication number:
**WO 2023/243566 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.06.2022 JP 2022095341**

(71) Applicant: **Tosoh Corporation
Yamaguchi 746-8501 (JP)**

(72) Inventors:
• **KUSUSE, Yoshiro**
  **Ayase-shi, Kanagawa 252-1123 (JP)**
• **IIHAMA, Junya**
  **Ayase-shi, Kanagawa 252-1123 (JP)**
• **HARA, Shinichi**
  **Ayase-shi, Kanagawa 252-1123 (JP)**
• **MESUDA, Masami**
  **Ayase-shi, Kanagawa 252-1123 (JP)**

(74) Representative: **Müller-Boré & Partner
Patentanwälte PartG mbB
Friedenheimer Brücke 21
80639 München (DE)**

(54) **GALLIUM NITRIDE SINTERED COMPACT AND METHOD FOR PRODUCING SAME**

(57)    Provided is at least one of a gallium nitride sintered body; a method for industrially producing the sintered body; a sputtering target including the sintered body; and a method for depositing a film with the sputtering target. With the gallium nitride sintered body, a sputtered film can be deposited at a faster deposition rate than with a gallium nitride sintered body produced by a hot-pressing process. A gallium nitride sintered body has a standard deviation of a porosity of 1.0% or less as determined from a scanning electron microscope image of a cross section of the gallium nitride sintered body.

EP 4 538 412 A1

**Description**

TECHNICAL FIELD

The present disclosure relates to a gallium nitride sintered body and to a gallium nitride sintered body suitable as a sputtering target.

BACKGROUND ART

Gallium nitride sintered bodies, in other words, polycrystalline bodies of gallium nitride, are less expensive than single-crystal gallium nitride, and for this reason, they are being studied for applications as a sputtering target for depositing a gallium nitride film. However, gallium nitride sintered bodies have a high oxygen content, low strength, a low density and the like compared to single-crystal gallium nitride and, in this regard, require improvement. Accordingly, various studies on the improvement have been conducted to date. Gallium nitride has, in particular, low moldability. Accordingly, the industrial production of gallium nitride sintered bodies is carried out by a hot-pressing process, which is a process in which a pressure is applied to a gallium nitride powder loaded in a mold made of carbon (C), to cause molding and sintering to proceed simultaneously (e.g., Patent Document 1).

PRIOR ART DOCUMENTS

PATENT DOCUMENTS

Patent Document 1: JP-A-2020-75851

DISCLOSURE OF INVENTION

TECHNICAL PROBLEM

In the hot-pressing process, there are instances in which carbon in a small amount, less than or equal to a measurement limit, is unintentionally introduced into the sintered body. As a result, sputtered films produced with a gallium nitride sintered body produced by the hot-pressing process tend to have a high carbon content.
An object of the present disclosure is to provide at least one of a gallium nitride sintered body; a method for industrially producing the sintered body; a sputtering target including the sintered body; and a method for depositing a film with the sputtering target. With the gallium nitride sintered body, a sputtered film can be deposited at a faster deposition rate than with a gallium nitride sintered body produced by a hot-pressing process.

SOLUTION TO PROBLEM

The present inventors investigated an approach of molding gallium nitride first and thereafter performing the sintering, and, accordingly, they paid attention to the moldability of gallium nitride. As a result, it was discovered that when gallium nitride has a composition controlled to be within a specific range, the moldability is significantly improved, which makes it possible to prepare a gallium nitride green body without using a heated atmosphere, and in addition, it was discovered that such a green body can be sintered by a sintering method other than the hot-pressing process. Furthermore, it was discovered that the sintered body produced by a sintering method other than the hot-pressing process has a structure different from those of the related art and that that structure makes the sintered body suitable as a sputtering target.
Specifically, the present invention is as described in the Claims, and a summary of the present disclosure is as follows.

[1] A gallium nitride sintered body having a standard deviation of a porosity of 1.0% or less as determined from a scanning electron microscope image of a cross section of the gallium nitride sintered body.
[2] The sintered body according to [1], wherein an average porosity is 25% or less.
[3] The sintered body according to [1] or [2], wherein an oxygen content is 0.4 atom % or less.
[4] The sintered body according to any one of [1] to [3], wherein a ratio of a molar amount of gallium to a total molar amount of the gallium and nitrogen is 0.5 or less.
[5] The sintered body according to any one of [1] to [4], wherein a bulk density is 4.0 g/cm$^3$ or greater.
[6] A method for producing the sintered body according to any one of [1] to [5], the method comprising the steps of:

preparing a green body by molding a powder that has a Ga/(Ga+N) ratio of greater than 0.5 and contains gallium nitride and gallium metal; and

sintering the green body in a nitriding atmosphere.

[7] The production method according to [6], wherein the step of preparing the green body is a step of subjecting the powder to uniaxial pressing to form a primary green body and then subjecting the primary green body to CIP molding.

[8] The production method according to [6] or [7], wherein the nitriding atmosphere includes at least one gas selected from the group of a nitrogen-hydrogen mixture gas, an ammonia gas, a hydrazine gas and an alkylamine gas.

[9] A gallium nitride green body having a Ga/(Ga+N) ratio of greater than 0.5.

[10] A sputtering target comprising the sintered body according to any one of [1] to [5].

[11] A method for producing a sputter film, the method comprising using the sputtering target according to [10].

ADVANTAGEOUS EFFECTS OF INVENTION

The present disclosure can provide at least one of a gallium nitride sintered body; a method for industrially producing the sintered body; a sputtering target including the sintered body; and a method for depositing a film with the sputtering target. With the gallium nitride sintered body, a sputtered film can be deposited at a faster deposition rate than with a gallium nitride sintered body produced by a hot-pressing process.

BRIEF DESCRIPTION OF DRAWINGS

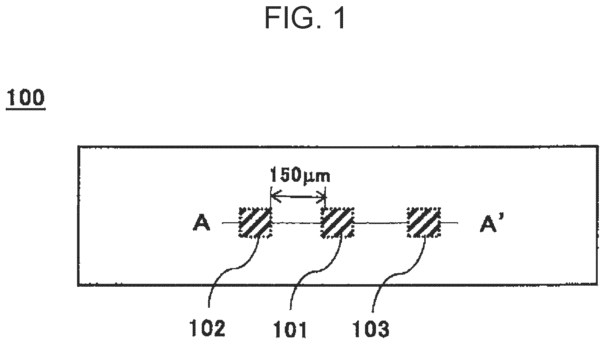

[Fig. 1] A schematic diagram illustrating observation fields used to measure an average porosity and SDρ.

DESCRIPTION OF EMBODIMENTS

The present disclosure will now be described with reference to an example of an embodiment.

[Gallium Nitride Sintered Body]

A sintered body of the present embodiment is a gallium nitride sintered body having a standard deviation of a porosity of 1.0% or less as determined from a scanning electron microscope image of a cross section of the gallium nitride sintered body.

The present embodiment relates to the gallium nitride sintered body. The gallium nitride (GaN) sintered body is a sintered body in which gallium nitride is present as a major component (matrix or base phase) and which is a polycrystalline body of gallium nitride. The sintered body is made primarily of gallium nitride and is so-called sintered gallium nitride. The sintered body of the present embodiment may contain one or more components other than gallium nitride, such as gallium metal.

The sintered body of the present embodiment may contain one or more dopant elements. A dopant element for producing an n-type semiconductor may be at least one selected from the group of silicon (Si), germanium (Ge), tin (Sn) and lead (Pb). A dopant element for producing a p-type semiconductor may be at least one selected from the group of beryllium (Be), magnesium (Mg), calcium (Ca), strontium (Sr), vanadium (Ba), zinc (Zn) and cadmium (Cd). A dopant element for producing an LED that displays a desired color may be at least one of aluminum (Al) and indium (In). A major dopant element that may be included in the sintered body of the present embodiment may be, for example, at least one selected from the group of silicon, magnesium, aluminum and indium.

A content of the dopant element may be any amount that is sufficiently small relative to the amount of gallium nitride. The content depends on the type of the dopant element. The content of the dopant element may be, for example, 0 atom % or greater or greater than 0 atom % and 25 atom % or less, 15 atom % or less, 1 atom % or less or 0.1 atom % or less.

Ideal sintered bodies have no pores and, thus, have a porosity of 0%. Actual sintered bodies, however, include pores. The porosity of the sintered body of the present embodiment is greater than 0%. It is preferable that the sintered body be dense, and the sintered body may have an average porosity of 1% or greater or 10% or greater. The average porosity of the sintered body of the present embodiment may be any value within a range of 25% or less or 20% or less so that the sintered body can exhibit mechanical properties sufficient for sputtering target applications.

The sintered body of the present embodiment has a standard deviation of the porosity (hereinafter also referred to as "SDρ") of 1.0% or less as determined from a scanning electron microscope image of a cross section of the gallium nitride sintered body. Preferably, the standard deviation of the porosity is 0.8% or less. When the SDρ is greater than these values, the structure of the sintered body, in particular, the structure of an inner portion of the sintered body, is non-uniform. Performing sputtering with such a sintered body increases the probability of formation of particles and, in addition, decreases a deposition rate. Preferably, the SDρ is ideally 0%. Actual sintered bodies, however, have pores, and a distribution of the pores and their porosity vary. The SD$\rho$ of the sintered body of the present embodiment may be, for example, greater than 0%, 0.1% or greater or 0.3% or greater.

One possible reason that the sintered body of the present embodiment has such an SD$\rho$ is that the amount of carbon that is unintentionally introduced as an impurity is small. Since carbon is sintering-resistant, the introduction of carbon, even in an amount less than or equal to the detection limit, hinders the sintering of gallium nitride. In this regard, the sintered body of the present embodiment, compared to sintered bodies of the related art, has a low carbon content, which facilitates the progression of sintering. As a result, presumably, the sintered body has a uniform structure. This can be confirmed by the fact that a sputtered film (sputter film) produced with the sintered body of the present embodiment has a lower carbon content.

In the present embodiment, the average porosity and the SD$\rho$ can be determined by performing a scanning electron microscope (hereinafter also referred to as "SEM") observation on a cross section of the sintered body. The SEM observation can be performed with a common SEM (e.g., JSM-IT800, manufactured by Jeol Ltd.), using a cut surface that results from cutting the sintered body as the observation surface. Before the SEM observation, the cut surface may be subjected to ion milling or cryo-ion milling to serve as the observation surface. As illustrated in Fig. 1, observation fields can be three fields defined as follows. One of the observation fields is a middle region (observation field 1, denoted as 101 in Fig. 1) of the cut surface, another is a region (observation field 2, denoted as 102 in Fig. 1) located 150 $\mu$m from an end of the observation field 1 on a straight line (line segment A-A' in Fig. 1) passing through the observation field 1, and the remaining one is a region (observation field 3, denoted as 103 in Fig. 1) located 150 $\mu$m from the observation field 1 on the straight line in a direction opposite to the direction pointing toward the observation field 2 from the observation field 1. The observation fields are rectangular regions measuring 250 $\mu$m × 180 $\mu$m. Specifically, Fig. 1 illustrates three rectangular observation fields measuring 250 $\mu$m × 180 $\mu$m that are disposed in a straight line at a spacing of 150 $\mu$m. Conditions for the SEM observation are as follows.

Acceleration voltage: 5 kV
Magnification: 500×

Next, image analysis is performed on the acquired SEM images with a common image analysis software (e.g., Image-Pro 10, manufactured by Hakuto Co., Ltd.), to detect pores and their areas. The pores [$\mu$m$^2$] can be detected from binarized images of the SEM images. The porosity of each of the SEM images can be determined according to the following equation.

$$\text{Porosity [\%]} = \{\text{area [μm}^2\text{] of pores/area [μm}^2\text{] of SEM observation surface}\} \times 100$$

The average porosity can be determined as an average of the porosities determined for three measurement sites, which are, for example, the observation field 1, the observation field 2 and the observation field 3. Specifically, the measurement sites are surface portions with a size of 45000 $\mu$m$^2$ or greater.

The SD$\rho$ can be determined from the standard deviation of the porosity of each of the measurement sites.

Preferably, the sintered body of this embodiment has a bulk density of 4.0 g/cm$^3$ or greater or 4.2 g/cm$^3$ or greater. When the sintered body has such a bulk density, a sufficient strength is likely to be achieved in instances in which the sintered body of the present embodiment is used as a sputtering target. While higher bulk densities are more preferable, the bulk density may be, for example, 5.0 g/cm$^3$ or less, 4.8 g/cm$^3$ or less or 4.7 g/cm$^3$ or less.

In the present embodiment, the "density" is a bulk density measured by a method that is in accordance with JIS R 1634, and a pretreatment therefor can be performed by a vacuum method that uses distilled water.

The sintered body of the present embodiment may have any average grain size within a range of 0.1 $\mu$m or greater or 0.2 $\mu$m or greater. The average grain size may be, for example, 0.5 $\mu$m or less or 0.3 $\mu$m or less.

In the present embodiment, the average grain size can be determined by performing scanning electron microscopy and electron backscatter diffraction (hereinafter also referred to as "SEM-EBSD") on a cross section of the sintered body. The SEM-EBSD observation can be performed on SEM images with a common EBSD (e.g., Symmetry, manufactured by Oxford Instruments). The SEM images can be acquired in a manner similar to that for the average porosity). The conditions for the EBSD observation are as follows.

Acceleration voltage: 15 kV
Tilt of sample: 70 degrees
Tilt correction: 0°
Magnification: 500×
Step size: 0.2 $\mu$m

Boundaries having a misorientation angle of 5° or greater can be considered to be grain boundaries, and regions surrounded by the grain boundaries can be considered to be grains. The grain size can be determined as a calculated diameter of a circle having an area equivalent to the area of each of the grains. The SEM-EBSD observation is performed on the grains observed in three fields (the number of grains is, for example, 10,0000 to 30,000 per field); the fields are defined in a manner similar to that for the average porosity. Then, image analysis is performed to calculate the average grain sizes of the individual fields. These average grain sizes can be averaged to give the average grain size.

In the sintered body of the present embodiment, a ratio of a molar amount of gallium to a total molar amount of the gallium and nitrogen is 0.5 or less (the ratio [mol/mol] is hereinafter also referred to as a "Ga/(Ga+N) ratio"). When the Ga/(Ga+N) ratio is such a value, the gallium present in the sintered body of the present embodiment is substantially entirely gallium nitride. That is, Ga metal is fully nitrided, and the sintered body does not contain Ga metal. The Ga/(Ga+N) is preferably less than 0.5 or 0.49 or less and may be 0.45 or greater or 0.47 or greater.

Preferably, the sintered body of the present embodiment has an oxygen content of 0.4 atom % or less or 0.2 atom % or less. Preferably, the sintered body of the present embodiment does not contain oxygen (i.e., the oxygen content is 0 atom %). The oxygen content may be, for example, 0 atom % or greater, greater than 0 atom %, 0.01 atom % or greater or 0.1 atom % or greater. When the oxygen content is such an amount, films that are produced by using the sintered body as a sputtering target are likely to exhibit properties more suitable for applications such as those in light emitting diodes or power semiconductor devices. Specifically, the oxygen content may be, for example, 0.1 atom % or greater and 0.3 atom % or less or 0.13 atom % or greater and 0.2 atom % or less.

A composition of the sintered body of the present embodiment can be considered to be a composition represented by the following equation.

$$100 = W_{Ga} \text{ [mass\%]} + W_O \text{ [mass\%]} + W_N \text{ [mass\%]} + W_X \text{ [mass\%]} \quad (1)$$

In equation (1), $W_{Ga}$, $W_O$, $W_N$ and $W_X$ are, respectively, mass ratios of gallium, oxygen, nitrogen and one or more dopant elements in the sintered body. $W_O$ and $W_N$ are values measured by performing pyrolysis that thermally decomposes the sintered body, by using a common oxygen-nitrogen analyzer (e.g., Leco ON736, manufactured by Leco), and Wx is a value measured by glow discharge mass spectrometry. $W_{Ga}$ is a value determined from the measured values of $W_O$, $W_N$ and $W_X$ according to equation (1).

The oxygen content is a value determined by equation (2), shown below.

$$\text{Oxygen content [atom \%]} = (W_O/M_O)/\{(W_{Ga}/M_{Ga}) + (W_N/M_N) + (W_O/M_O) + (W_X/M_X)\} \quad (2)$$

In equation (2), Mo is an atomic mass of oxygen (16.00 [g/mol]), $M_{Ga}$ is a gallium content of oxygen (69.72 [g/mol]) and $M_N$ is the atomic mass of nitrogen (14.01 [g/mol]). Mx is the atomic mass of one or more dopant elements, examples of which include the atomic mass of silicon (28.09 [g/mol]), the atomic mass of magnesium (24.31 [g/mol]), the atomic mass of aluminum (26.98 [g/mol]) and the atomic mass of indium (114.82 [g/mol]).

The Ga/(Ga+N) ratio is a value determined by equation (3), shown below.

$$\text{Ga/(Ga+N) ratio} = (W_{Ga}/M_{Ga})/\{(W_{Ga}/M_{Ga}) + (W_N/M_N)\} \quad (3)$$

Preferably, the sintered body of the present embodiment has a Vickers hardness of 100 HV or greater or 150 HV or greater, so that the sintered body can exhibit mechanical properties suitable for use as a sputtering target. The Vickers hardness may be any value that is suitably high and may be, for example, 1000 HV or less, 300 HV or less or 250 HV or less.

In the present embodiment, the Vickers hardness may be any value measured by a method that is in accordance with JIS B7725. The Vickers hardness can be determined as follows: a pyramidal indenter is pressed against the sintered body with a force of 1 kgf, then, the resulting impression is observed with a microscope, and a surface area of the impression is calculated from a horizontal distance of the diagonal.

The sintered body of the present embodiment may have a flexural strength of 20 MPa or greater, 30 MPa or greater or 50 MPa. Such flexural strengths are preferable for a similar reason. Furthermore, the flexural strength may be, for example, 150 MPa or less, 100 MPa or less or 60 MPa or less.

In the sintered body of the present embodiment, parameters may have any upper and lower limits selected from the above-mentioned values in any combination, where the parameters include the average porosity, the SDρ, the bulk density, the average grain size, the Ga/(Ga+N) ratio, the oxygen content, the content of the dopant element, the Vickers hardness and the flexural strength.

The sintered body of the present embodiment can be used in applications known in the art of gallium nitride sintered bodies. Preferably, the sintered body may be made to be a sintered body for sputtering targets.

[Method for Producing Sintered Body]

A method for producing the sintered body of the present embodiment is a method for producing a sintered body comprising the steps of preparing a green body and sintering the green body in a nitriding atmosphere. The green body is prepared by molding a powder that has a Ga/(Ga+N) ratio of greater than 0.5 and contains gallium nitride and gallium metal. Thus, it is possible to industrially produce a sintered body having a desired shape that is not restricted by the shape of a mold of a firing furnace.

The powder (hereinafter also referred to as a "raw material powder") that is subjected to the step (hereinafter also referred to as a "molding step") of preparing a green body by molding a powder that has a Ga/(Ga+N) ratio of greater than 0.5 and contains gallium nitride and gallium metal may be any powder that contains gallium nitride and gallium metal. For example, the powder may be a mixed powder of gallium nitride and gallium metal.

The Ga/(Ga+N) ratio of the raw material powder is greater than 0.5 and preferably 0.51 or greater. When the raw material powder has such a composition, the molding is facilitated even in an atmosphere that is not a heated atmosphere. In the present embodiment, one possible reason that the raw material powder can be molded in an atmosphere that is not a heated atmosphere or, in particular, not an atmosphere for simultaneously performing molding and sintering, is that gallium metal is present between gallium nitride particles, which results in increased flowability of particles and increased bond strength between particles. Consequently, it is possible to produce a green body having a high shape stability compared to a green body that is substantially free of gallium metal and formed of only gallium nitride. The Ga/(Ga+N) ratio may be any value within a range of 0.6 or less or 0.55 or less.

The raw material powder may be a powder composed of gallium nitride and gallium metal. The raw material powder may contain a dopant element for imparting properties that suit an application, such as semiconductor properties. The dopant element that may be included in the raw material powder may be present in a compound; the compound may contain at least one selected from the group of silicon (Si), germanium (Ge), tin (Sn), lead (Pb), magnesium (Mg), calcium (Ca), strontium (Sr), barium (Ba), zinc (Zn), indium (In) and aluminum (Al) or may contain at least one selected from the group of silicon, magnesium, indium and aluminum.

The raw material powder may contain at least one selected from the group of silicon, germanium, tin and lead so that the resulting sintered body can exhibit n-type semiconductor properties. Alternatively, the raw material powder may contain at least one selected from the group of magnesium, calcium, strontium, barium and zinc so that the resulting sintered body can exhibit p-type semiconductor properties. The raw material powder may contain at least one of indium and aluminum so that the resulting sintered body can have a different bandgap. The dopant element included in the raw material powder may be any type of dopant element that is appropriately selected to conform to the sintered body of interest. The content of the dopant element may be any value that is the same as the content of the dopant element of the above-described sintered body of the present embodiment. That is, the content of the dopant element does not change before and after sintering. The content of the dopant element in the sintered body is equal to the content of the element in the raw material powder that is subjected to sintering.

Preferably, the raw material powder has an oxygen content of 1 atom % or less, 0.5 atom % or less or 0.3 atom % or less, so that the resulting sintered body can have a low oxygen content. It is preferable that the raw material powder not contain oxygen (i.e., the oxygen content be 0 atom %). However, the raw material powder may contain oxygen to an extent that the properties of the resulting sintered body are not affected, and the oxygen content of the raw material powder may be, for example, 0.005 atom % or greater or 0.01 atom % or greater.

In the present embodiment, the oxygen content of the raw material powder is a value measured by a method that is in accordance with JIS H 1695.

The raw material powder may have a specific surface area of 0.01 $m^2$/g or greater so that the oxygen content can be easily reduced. Preferably, the specific surface area is 1.5 $m^2$/g or less or less than 0.8 $m^2$/g.

In the present embodiment, the specific surface area of the raw material powder is a value measured by a method that is in accordance with JIS R 1626:1996.

The raw material powder may have an untamped bulk density of 1.0 $g/cm^3$ or greater or 1.4 $g/cm^3$ or greater. This is preferable because in this case, the resulting sintered body is likely to have high strength. The untamped bulk density may be any value within a range of less than 3.0 $g/cm^3$ or 2.5 $g/cm^3$; in this case, moldability is likely to be improved.

In the present embodiment, the untamped bulk density of the raw material powder is a value measured by a method that is in accordance with JIS Z 2504.

Preferably, the raw material powder has an average particle size of 1 $\mu$m or greater, 5 $\mu$m or greater or 9 $\mu$m or greater and 150 $\mu$m or less, 100 $\mu$m or less or 80 $\mu$m or less.

In the present embodiment, the average particle size of the raw material powder is an averaged value determined as follows. In a scanning electron microscope (hereinafter also referred to as an "SEM") image acquired under the following conditions, areas of 1200±400 primary particles are determined, and their equivalent circular diameters are measured from the areas and averaged.

Acceleration voltage: 10 kV
Magnification: 50 to 5000×

The SEM observation for the measurement of the average particle size can be carried out by using a common SEM (e.g., VE-9800, manufactured by Keyence Corporation). Only primary particles that can be entirely identified in the SEM image are to be selected for the measurement. Multiple SEM images may be used so that the number of particles can be the above-mentioned number.

In the molding step, the raw material powder is molded to form a green body. The molding may be carried out by any method that can produce a green body having a desired shape. The molding method may be, for example, at least one of uniaxial pressing and cold isostatic pressing (hereinafter also referred to as "CIP"). Either of these molding methods can produce the green body (green compact). In the molding step, the molding of the raw material powder is preferably carried out without heating the raw material powder, and the molding of the raw material powder is preferably carried out at room temperature ($25\pm10°C$). It is preferable that the Ga/(Ga+N) ratio not change before and after the molding. That is, it is preferable that the Ga/(Ga+N) ratio of the raw material powder be equal to the Ga/(Ga+N) ratio of the green body. Molding methods that do not cause the Ga/(Ga+N) ratio to change before and after the molding provide a high degree of shape flexibility of the green body.

Particularly preferably, the molding may be carried out by subjecting the raw material powder to uniaxial pressing to form a primary green body and then subjecting the primary green body to CIP molding. The uniaxial pressing may be performed under any conditions that enable the production of a primary green body having a shape retention property that is sufficient for preventing the formation of defects when the primary green body is subjected to CIP molding. With such a molding method, the Ga/(Ga+N) ratio does not change before and after the molding. The uniaxial pressing may be performed at a pressure of, for example, 10 MPa or greater or 25 MPa or greater and 200 MPa or less or 300 MPa or less. The CIP molding may be carried out under any conditions that enable the production of the green body, which will be described below. For example, the CIP molding may be performed at a pressure of 100 MPa or greater or 200 MPa or greater and 400 MPa or less or 500 MPa or less.

The production method of the present embodiment includes a step of sintering the green body in a nitriding atmosphere (hereinafter also referred to as a "sintering step"). Since the material to be sintered is a green body having a stable shape, it is possible to produce a sintered body having a desired size and shape derived from the size and shape of the green body. In addition, it is possible to produce a larger sintered body than with a sintering method of the related art, such as a hot-pressing (hereinafter also referred to as "HP") process, in which molding and sintering are integrally performed.

The green body that is subjected to the sintering step may be any green body that has a composition similar to that of the raw material powder. The green body may be a green body that has a Ga/(Ga+N) ratio of greater than 0.5 and contains gallium nitride and gallium metal. Preferably, the Ga/(Ga+N) ratio of the green body is 0.51 or greater. The Ga/(Ga+N) ratio of the green body may be any value within a range of 0.6 or less or 0.55 or less.

Since the raw material powder of the present embodiment need not be molded in a heated atmosphere, it is possible to produce a gallium nitride green body having a desired shape. The shape of the green body may be any shape that is desired, which may be at least one selected from the group of disc shapes, columnar shapes, rectangular shapes, polyhedral shapes and conical or pyramidal shapes or may be any other shape that suits a purpose or use.

While the size of the green body may be any size, the green body may be produced as a large green body because the raw material powder of the present embodiment can be molded in a non-heated atmosphere, such as a room temperature atmosphere. Examples of a green body suitable as a precursor of a sintered body that is used as a sputtering target include plate-shaped green bodies and disc-shaped green bodies. Since the raw material powder has high moldability, the green body can be formed to have a shape including a surface having an area of 100 $mm^2$ or greater or 1,000 $mm^2$ or greater. The area of the surface may be, for example, 100,000 $mm^2$ or less, 20,000 $mm^2$ or less or 5,000 $mm^2$ or less.

Specifically, the shape of the green body may be, for example, a disc shape with a diameter of 5 $mm^2$ or greater or 10 $mm^2$ or greater and 300 $mm^2$ or less or 150 $mm^2$ or less.

The green body may have a measured density of 3.0 $g/cm^3$ or greater or 3.6 $g/cm^3$ or greater and 5.8 $g/cm^3$ or less or 5.5 $g/cm^3$ or less.

In the present embodiment, the measured density of the green body is a value measured by a method that is in accordance with JIS Z 8807.

In the sintering step, the green body is sintered in a nitriding atmosphere. The sintering in a nitriding atmosphere nitrides the gallium metal present in the green body to yield gallium nitride. Accordingly, a sintered body having a Ga/(Ga+N) ratio of the present embodiment can be obtained. In the related art, gallium nitride sintered bodies (polycrystalline bodies) are produced by the HP process, in which molding and sintering simultaneously proceed. In the HP process, since a pressure is applied to the raw material powder that has been loaded in a mold, the shape of the resulting green body is limited by the shape of the mold, and in addition, unintentional introduction of impurities from the mold is likely to occur. In contrast, in the present embodiment, a green body that has an imparted shape is sintered with no applied pressure, and, therefore, the sintering does not necessarily require a mold. That is, the shape of the green body does not rely on the mold included in an HP machine. Accordingly, the green body has a high degree of shape flexibility. Furthermore, in industrial HP processes, molds made of carbon are primarily used. In this regard, the production method of the present embodiment can prevent unintentional introduction of impurities from a mold, in particular, unintentional introduction of carbon (C). As a result, in instances where a sputter film is deposited with a sputtering target including the sintered body of the present embodiment, the resulting sputter film has a lower carbon content. From the standpoint of avoiding unintentional introduction of impurities, in particular, unintentional introduction of carbon, it is preferable that the production method of the present embodiment not include any HP processes, in particular, an HP process that includes a mold made of carbon.

In the present embodiment, the "nitriding atmosphere" is an atmosphere in which a nitridation reaction is allowed to proceed, or, in particular, an atmosphere in which a nitridation reaction is allowed to proceed, but oxidation reactions are not allowed to proceed. Accordingly, the nitriding atmosphere is not limited to a nitrogen atmosphere and may be an atmosphere containing an element other than nitrogen. The nitriding atmosphere may be, for example, an atmosphere containing at least one of nitrogen and a nitrogen compound. Preferably, the atmosphere is at least one selected from the group of a nitrogen-hydrogen mixture gas, an ammonia gas, a hydrazine gas and an alkylamine gas; at least one of an ammonia gas and a nitrogen-hydrogen mixture gas; or an ammonia gas.

Particularly preferably, the nitriding atmosphere may be a flowing atmosphere, a nitrogen-compound-flowing atmosphere or an ammonia-flowing atmosphere. When the atmosphere is a flowing atmosphere, that is, an atmosphere in which an atmosphere medium, such as a nitrogen compound-containing gas, is flowing, the nitridation reaction of the gallium metal is promoted. Consequently, the resulting sintered body has a more uniform composition. The flowing atmosphere may be in any state in which the atmosphere medium is fluid. For example, the flowing atmosphere may have a flow rate of 0.1 mL/min or greater or 1 L/min or greater. The flow rate may be appropriately selected to suit the green body that is subjected to the process and the properties of the sintering furnace. The flow rate may be, for example, 20 L/min or less or 10 mL/min or less.

In the sintering step, it is preferable that the sintering be performed without applying any pressure to the green body (material to be sintered), and it is preferable that the sintering be performed without applying any molding pressure to the green body.

In the sintering step, a holding temperature may be any value at which the sintering of gallium nitride proceeds. Furthermore, unlike the case of the HP process and the like, the green body that is subjected to the sintering step has a stable shape. Accordingly, even if the holding temperature is lower than that of sintering methods, such as HP processes, in which molding and sintering simultaneously proceed, it is possible to produce a sintered body having a high density. Accordingly, a sintering temperature may be, for example, 1100°C or less, 1050°C or less or 1000°C or less. The holding temperature may be 800°C or greater, 900°C or greater or 950°C or greater.

A holding time associated with the holding temperature varies depending on the holding temperature, a size of the green body, the properties of the sintering furnace that is used and the like. The holding time associated with the holding temperature may be, for example, 1 hour or more and 20 hours or less or 2 hours or more and 10 hours or less.

In the production method of the present embodiment, parameters may have any upper and lower limits selected from the above-mentioned values in any combination, where the parameters include the Ga/(Ga+N) ratio, the area of the surface of the green body, the measured density of the green body, the flow rate of the atmosphere medium, the holding temperature and the holding time.

[Sputtering Target]

Now, a sputtering target including the sintered body of the present embodiment will be described.

The sputtering target including the sintered body of the present embodiment (hereinafter also referred to as a "target of the present embodiment") is a sputtering target including a support and the sintered body of the present embodiment, which is bonded to the support via a bonding layer.

The target of the present embodiment may have any shape, which, for example, may be at least one of a flat plate shape and a cylindrical shape or may be any other shape that suits the use.

In the target of the present embodiment, the sintered body of the present embodiment is bonded (i.e., attached by bonding) to a support via a bonding layer. The bonding layer may be any layer formed of a solder containing at least one selected from the group of tin, indium and zinc. It is preferable that the bonding layer be formed of an indium-containing solder, because in this case, the target is likely to have high electrical conductivity and thermal conductivity. In the instance where the bonding layer is formed of an indium-containing solder, the target of the present embodiment may include a layer for improving wettability (hereinafter also referred to as a "barrier layer") between the gallium nitride sintered body and the bonding layer. In this case, the wettability of the sintered body with respect to indium is improved, which results in stronger bonding between the sintered body and the bonding layer. The barrier layer may be formed of any component that has high wettability with respect to indium, and the component is preferably at least one of nickel and chromium.

It is preferable, in terms of an increase in cost, that the target of the present embodiment not include any layer containing tungsten (W). In particular, it is preferable that no tungsten-containing layer be included as the barrier layer.

Preferably, the support of the target of the present embodiment is formed of at least one selected from the group of copper, stainless steel and titanium. The support may have any desired shape that conforms to the shape of the sintered body of the present embodiment. For example, the shape of the support may be at least one of a flat plate shape and a cylindrical shape or may be any other shape that suits the use.

[Method for Depositing Film]

Now, a method for producing (method for depositing) a sputter film by using the target of the present embodiment will be described.

The sputter film is formed on a substrate by performing sputtering with the target of the present embodiment. Accordingly, a sputter film, a gallium nitride film or a gallium nitride thin film can be deposited.

The sputtering may be performed, for example, by at least one method selected from the group of DC sputtering methods, pulsed DC sputtering methods, RF sputtering methods, AC sputtering methods, DC magnetron sputtering methods, RF magnetron sputtering methods and ion beam sputtering methods. Preferably, the method may be at least one of a DC magnetron sputtering method and an RF magnetron sputtering method.

A sputtering gas may be any gas that can be used for sputtering. The sputtering gas may be an inert gas or may be at least one of an argon gas and a nitrogen gas. In instances where the sputtering is performed with the target of the present embodiment, the sputtering gas may preferably be a nitrogen-containing gas or may preferably be an argon-nitrogen mixture gas because in these cases, the resulting sputtered film is likely to have a smooth surface. The mixture gas preferably has an excess of nitrogen and preferably has a partial pressure ratio [Pa/Pa] of nitrogen/(nitrogen + argon) of greater than 0.5, 0.7 or greater or 0.9 or greater.

The sputtering gas may have a flow rate of 5 ml/min or greater or 10 ml/min or greater and 100 ml/min or less or 70 ml/min or less.

The sputtering gas may have a gas pressure of 0.05 Pa or greater or 0.1 Pa or greater and 3 Pa or less or 2 Pa or less.

For the sputtering, a discharge power density may be any value within a range of 0.1 $W/cm^2$ or greater or 0.3 $W/cm^2$ or greater and 5 $W/cm^2$ or less, so that a plasma can be stably generated.

The substrate may be appropriately selected to suit the multilayer body formed of the film of interest and the substrate (hereinafter also referred to as a "multilayer body"). For example, the substrate may be at least one selected from the group of glass substrates, alumina substrates, silicon substrates, gallium nitride substrates, aluminum nitride substrates and silicon carbide substrates or may be at least one of an alumina substrate, a silicon substrate and a gallium nitride substrate.

The method for sputtering and conditions therefor may be appropriately selected to suit the sputtered film of interest.

A temperature of the substrate during the film deposition performed by sputtering (hereinafter also referred to as a "deposition temperature") may be any value within a range of 10°C or greater or 20°C or greater and 800°C or less. In instances where the deposition rate is to be increased, the deposition temperature may be, for example, 100°C or greater or 300°C or greater and 800°C or less or 500°C or less.

A duration of the sputtering (hereinafter also referred to as a "deposition time") can be appropriately selected depending on the sputtering conditions, a size of the substrate and a thickness of the sputter film of interest. For example, the duration may be any value within a range of 1 minute or more or 10 minute or more and 5 hours or less or 1 hour or less.

EXAMPLES

The present disclosure will now be described with reference to Examples. Note that the present disclosure is not limited to the Examples.

(Average Porosity and SDρ)

A measurement surface was prepared as follows. A sintered body was cut to expose a cut surface of a middle of the sintered body, and then, the cut surface was subjected to cryo-Ar ion milling. In a manner illustrated in Fig. 1, observation fields 1, 2 and 3 of the cut surface were observed with an SEM. The SEM observation was performed with a common SEM (instrument name: JSM-IT800, manufactured by Jeol Ltd.) under the following conditions.

Acceleration voltage: 5 kV

Magnification: 500×

Next, image analysis was performed on the acquired SEM images after they were binarized, with a common image analysis software (Image-Pro 10, manufactured by Hakuto Co., Ltd.), to detect pores and their areas. The porosity corresponding to each of the observation fields in the SEM images was determined according to the following equation.

$$\text{Porosity [\%]} = \{\text{area [μm}^2\text{] of pores/area [μm}^2\text{] of SEM observation surface}\} \times 100$$

The average porosity was determined as an average of the determined porosities of the three observation fields. The SD$\rho$ was determined from the standard deviations of the porosity of the observation fields.

(Average Grain Size)

Observation was performed on SEM images of three fields defined in a manner similar to that for the measurement of the average porosity and the SD$\rho$. A common EBSD instrument (instrument name: Symmetry, manufactured by Oxford Instruments) was used for the observation. The EBSD observation was performed under the following conditions.

Acceleration voltage: 15 kV
Tilt of sample: 70 degrees
Tilt correction: 0°
Magnification: 500×
Step size: 0.2 μm

Boundaries having a misorientation angle of 5° or greater were considered to be grain boundaries, and regions surrounded by the grain boundaries were considered to be grains. The grain size was determined as a calculated diameter of a circle having an area equivalent to the area of each of the grains. An average of the grains observed in the three fields defined in a manner similar to that for the average porosity was determined to give the average grain size.

(Bulk Density)

The bulk density of the sintered body was measured with a method that is in accordance with JIS R 1634. The pretreatment was performed with a vacuum method that used distilled water.

(Composition)

Mass ratios [mass%] of oxygen [mass%] and nitrogen in the sintered body were measured with an oxygen-nitrogen analyzer (instrument name: Leco ON736, manufactured by Leco), by using an inert gas fusion-infrared absorption method. By using the obtained mass ratios of oxygen and nitrogen, the mass ratio of gallium was determined according to equation (1), shown above, the oxygen content [atom %] was determined according to equation (2), shown above, and the Ga/(Ga+N) ratio was determined according to equation (3), shown above.

(Vickers Hardness)

The Vickers hardness of the sintered body was measured with a method that is in accordance with JIS Z 2244. The measurement was performed at five points per measurement sample, and the Vickers hardness was determined as an average of the values.

(Measurement of Flexural Strength)

A three-point flexural strength of the sintered body was measured with a method that is in accordance with JIS R 1601. The measurement was performed twice, and the flexural strength was determined as an average of the values.

(Carbon Content)

The carbon content of a sputter film was measured by secondary ion mass spectrometry (SIMS). The measurement was performed on a region extending from a surface of the thin film to a depth of 50 nm.

Example 1

8 g of a mixed powder of gallium metal and gallium nitride having a Ga/(Ga+N) ratio of 0.52 was prepared and loaded into a rectangular mold having a length of 10 mm and a width of 40 mm. After the loading, uniaxial pressing was performed at a pressure of 100 MPa to give a primary green body. Cold isostatic pressing was performed on the primary green body at a pressure of 300 MPa to give a CIP-processed body.

The CIP-processed body was placed on a setter made of alumina and then sintered in an atmospheric furnace under the following conditions to give a sintered body of this Example.

Heat treatment atmosphere: ammonia-flowing atmosphere
(flow rate of ammonia gas: 6000 mL/min)
Holding temperature: 980°C
Holding time: 5 hours

Example 2

A sintered body of this Example was prepared in a manner similar to that of Example 1, except that 8 g of a mixed powder of gallium metal and gallium nitride having a Ga/(Ga+N) ratio of 0.51 was used.

Example 3

A sintered body of this Example was prepared in a manner similar to that of Example 1, except that 8 g of a mixed powder of gallium metal and gallium nitride having a Ga/(Ga+N) ratio of 0.53 was used.

Example 4

A sintered body of this Example was prepared in a manner similar to that of Example 1, except that 8 g of a mixed powder of gallium metal and gallium nitride having a Ga/(Ga+N) ratio of 0.54 was used.

Comparative Example 1

8 g of a mixed powder of gallium metal and gallium nitride having a Ga/(Ga+N) ratio of 0.48 was loaded into a rectangular mold having a length of 10 mm and a width of 40 mm. After the loading, uniaxial pressing was performed at a pressure of 100 MPa for 180 seconds. When the resultant was removed from the mold, however, defects, such as flaws and cracks, were formed, and thus, the production of a primary green body was unsuccessful.

The Examples and the Comparative Example confirmed that compared to the powder that was gallium nitride-rich, the mixed powders that were gallium metal-rich, with the Ga/(Ga+N) ratio being 0.5 or greater, had high moldability and were able to be molded even at a temperature that was not high.

Comparative Example 2

300 g of a mixed powder of gallium nitride having a Ga/(Ga+N) ratio of 0.48 was loaded into a press mold made of carbon and having a diameter of 130 mm and was then hot-pressed under the following conditions.

Heat treatment atmosphere: vacuum

Heating rate: 200°C/hour

Holding temperature: 1060°C

Holding time: 3 hours

Press pressure: 40 MPa

Cooling rate: 200°C/hour

After the HP treatment, the gallium nitride sintered body was removed from the press mold made of carbon, to be designated as a sintered body of this Comparative Example.

The results of the Examples and the Comparative Example are shown in the table below.

[Table 1]

| | Average Porosity [%] | SD$\rho$ [%] | Ga/(Ga+N) Ratio | Oxygen Content [atom %] | Bulk Density [g/cm$^3$] | Vickers Hardness [HV] | Flexural Strength [MPa] |
|---|---|---|---|---|---|---|---|
| Example 1 | 17.2 | 0.5 | 0.49 | 0.17 | 4.4 | 185 | 25 |
| Example 2 | - | - | 0.48 | 0.16 | 4.5 | 223 | 35 |
| Example 3 | 17.2 | 0.7 | 0.48 | 0.15 | 4.7 | 284 | 55 |
| Example 4 | 16.2 | 0.3 | 0.49 | 0.29 | 4.8 | 889 | 97 |
| Comparative Example 2 | 20.4 | 1.1 | 0.53 | 0.50 | 4.1 | 46 | 48 |
| *In the table, "-" means not measured. | | | | | | | |

The sintered bodies of the Examples had an SD$\rho$ of 1.0% or less, and thus, the structures of the sintered bodies were confirmed to be uniform, compared to the sintered body of Comparative Example 2. The average grain sizes were 2.5 $\mu$m in Example 1, 2.1 $\mu$m in Example 3, 1.6 $\mu$m in Example 4 and 2.4 $\mu$m in Comparative Example 2.

Example 5

A sintered body of this Example was prepared in a manner similar to that of Example 1, except that the heat treatment atmosphere was an ammonia-flowing atmosphere (flow rate of ammonia gas: 2000 mL/min). The sintered body of this Example had a Ga/(Ga+N) ratio of 0.48 and an oxygen content of 0.23 atom %.

Example 6

A sintered body of this Example was prepared in a manner similar to that of Example 2, except that the holding temperature was 930°C, and the holding time was 1 hour. The sintered body of this Example had a Ga/(Ga+N) ratio of 0.49 and an oxygen content of 0.29 atom %.

Example 7

A sintered body of this Example was prepared in a manner similar to that of Example 3, except that the holding temperature was 1030°C, and the holding time was 1 hour. The sintered body of this Example had a Ga/(Ga+N) ratio of 0.49 and an oxygen content of 0.10 atom %.

The sintered body of Example 1 had an oxygen content of 0.17 atom %, whereas the sintered body of Example 5 had an oxygen content of 0.23 atom %. Thus, it was confirmed that an increase in the flow rate of ammonia facilitates the progress of reduction, which reduces the oxygen content.

The sintered body of Example 2 had an oxygen content of 0.16 atom %, whereas the sintered body of Example 6 had an oxygen content of 0.29 atom %. Thus, it was confirmed that improvement in the holding temperature for sintering reduces the oxygen content.

The sintered body of Example 3 had an oxygen content of 0.15 atom %, whereas the sintered body of Example 7 had an oxygen content of 0.10 atom %. Thus, it was confirmed that improvement in the holding temperature for sintering reduces the oxygen content, regardless of the flow rate of ammonia (6000 mL/min or 2000 mL/min). It is believed that the reduction in the amount of oxygen due to the improvement in the holding temperature had a greater influence than the increase in the amount of oxygen due to the reduction in the flow rate of ammonia.

Example 8

A sintered body of this Example was prepared in a manner similar to that of Example 1, except that 95 g of a mixed powder of gallium metal and gallium nitride having a Ga/(Ga+N) ratio of 0.52 was used and that the mixed powder was loaded into a rectangular mold measuring 60 mm $\times$ 60 mm.

Example 9

A sintered body of this Example was prepared in a manner similar to that of Example 1, except that 380 g of a mixed powder of gallium metal and gallium nitride having a Ga/(Ga+N) ratio of 0.52 was used and that the mixed powder was loaded into a circular mold having a diameter of 135 mm.

The results of evaluations of the sintered bodies obtained in these Examples are shown in the table below.

[Table 2]

|  | Shape | |
| --- | --- | --- |
|  | Shape | Area [mm$^2$] |
| Example 1 | Rectangular | 400 |
| Example 8 | Rectangular | 3600 |
| Example 9 | Circular | 14315 |

The above table confirms that in the Examples, not only circular sintered bodies but also rectangular sintered bodies were successfully produced. Furthermore, it is confirmed that in the Examples, large sintered bodies with a size of 1000 mm$^2$ or greater, or 10000 mm$^2$ or greater, were successfully produced.

[Evaluation of Film Deposition]

The sintered bodies obtained in Example 8 and Comparative Example 2 were each cut into a disc shape having a diameter of 101 mm. An indium-containing solder material was applied to the processed sintered bodies, and a copper backing plate was bonded to the resultants to form sputtering targets.

Sputtering was performed with the obtained sputtering targets under the following conditions to deposit gallium nitride films (sputter films).

Discharge method: RF sputtering
Substrate: $Al_2O_3$
Sputtering gas: nitrogen gas
Flow rate of sputtering gas: 50 sccm
Pressure of sputtering gas: 0.5 Pa
Discharge power density: 2.5 W/cm$^2$
Deposition temperature: 25°C
Deposition time: 60 min

The results of the evaluation of film deposition are shown in the table below. Note that in Example 9, the carbon content was not measured and is, therefore, indicated as "-".

[Table 3]

|  | Gallium Nitride Film | | |
| --- | --- | --- | --- |
|  | Film Thickness [nm] | Deposition Rate [nm/hour (h)] | Carbon Content [$\times 10^{18}$ atoms/cm$^3$] |
| Example 8 | 274 | 274 | 7 |
| Example 9 | 285 | 285 | - |
| Comparative Example 2 | 141 | 141 | 25 |

The sintered body of Example 8 was a sintered body equivalent to the sintered body of Example 1 except for the size of the sintered body and had an $SD_\rho$ lower than that of the sintered body of Comparative Example 2. The target of the Example had a deposition rate greater than or equal to 1.9 times that of the target of Comparative Example 2 and was, thus, confirmed to have a faster deposition rate. Furthermore, the gallium nitride film produced with the target of the Example had a carbon content less than or equal to one-third that of the gallium nitride film produced with Comparative Example 2, and thus, it was confirmed that the production of a sputter film having a low carbon content was achieved.

The present application is based on a Japanese patent application (Patent Application No. 2022-095341) filed on June 13, 2022, the entirety of which is incorporated herein by reference. Furthermore, all references cited herein are incorporated in their entireties.

REFERENCE SYMBOLS

100   sintered body

101   observation field 1

102   observation field 2

103   observation field 3

**Claims**

1. A gallium nitride sintered body having a standard deviation of a porosity of 1.0% or less as determined from a scanning electron microscope image of a cross section of the gallium nitride sintered body.

2. The sintered body according to claim 1, wherein an average porosity is 25% or less.

3. The sintered body according to claim 1 or 2, wherein an oxygen content is 0.4 atom % or less.

4. The sintered body according to any one of claims 1 to 3, wherein a ratio of a molar amount of gallium to a total molar amount of the gallium and nitrogen is 0.5 or less.

5. The sintered body according to any one of claims 1 to 4, wherein a bulk density is 4.0 g/cm$^3$ or greater.

6. A method for producing the sintered body according to any one of claims 1 to 5, the method comprising the steps of:

   preparing a green body by molding a powder that has a Ga/(Ga+N) ratio of greater than 0.5 and contains gallium nitride and gallium metal; and
   sintering the green body in a nitriding atmosphere.

7. The method according to claim 6, wherein the step of preparing the green body is a step of subjecting the powder to uniaxial pressing to form a primary green body and then subjecting the primary green body to CIP molding.

8. The method according to claim 6 or 7, wherein the nitriding atmosphere includes at least one gas selected from the group of a nitrogen-hydrogen mixture gas, an ammonia gas, a hydrazine gas and an alkylamine gas.

9. A gallium nitride green body having a Ga/(Ga+N) ratio of greater than 0.5.

10. A sputtering target comprising the sintered body according to claims 1 to 5.

11. A method for producing a sputter film, the method comprising using the sputtering target according to claim 10.

# FIG. 1

100

## INTERNATIONAL SEARCH REPORT

| International application No. |
|---|
| **PCT/JP2023/021587** |

### A. CLASSIFICATION OF SUBJECT MATTER

*C23C 14/34*(2006.01)i; *C04B 35/58*(2006.01)i; *C04B 35/64*(2006.01)i; *H01L 21/203*(2006.01)i
FI: C23C14/34 A; C04B35/58; C04B35/64; H01L21/203 S

According to International Patent Classification (IPC) or to both national classification and IPC

### B. FIELDS SEARCHED

Minimum documentation searched (classification system followed by classification symbols)

C23C14/34; C04B35/58; C04B35/64; H01L21/203

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2-228470 A (TOSHIBA CORP.) 11 September 1990 (1990-09-11) | 1, 4, 10, 11 |
|  | example 2 |  |
| Y |  | 2, 3, 5 |
| A |  | 6-9 |
| X | JP 2014-159368 A (TOSOH CORP.) 04 September 2014 (2014-09-04) | 9 |
|  | paragraphs [0013]-[0062] |  |
| Y |  | 2, 3, 5 |
| A |  | 1, 4, 6-8 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 August 2023** | **22 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/021587**

| Patent document cited in search report | | | Publication date (day/month/year) | Patent family member(s) | Publication date (day/month/year) |
|---|---|---|---|---|---|
| JP | 2-228470 | A | 11 September 1990 | (Family: none) | |
| JP | 2014-159368 | A | 04 September 2014 | US 2013/0273346 A1 paragraphs [0016]-[0066] US 2019/0106784 A1 WO 2012/086661 A1 EP 2657208 A1 EP 3088374 A1 TW 201238933 A CN 103270000 A KR 10-2013-0141605 A CN 105347800 A KR 10-2018-0030933 A | |

Form PCT/ISA/210 (patent family annex) (January 2015)

**REFERENCES CITED IN THE DESCRIPTION**

**Patent documents cited in the description**

- JP 2020075851 A

- JP 2022095341 A